Europäisches Patentamt

European Patent Office

Office européen des brevets

(19)

(11) **EP 0 590 323 B1**

(12) **EUROPÄISCHE PATENTSCHRIFT**

(45) Veröffentlichungstag und Bekanntmachung des Hinweises auf die Patenterteilung:
**02.06.1999 Patentblatt 1999/22**

(51) Int Cl.$^6$: **H03L 7/107**, H03L 7/093

(21) Anmeldenummer: **93113795.4**

(22) Anmeldetag: **28.08.1993**

(54) **Filter zur Einstellung der Bandbreite eines Regelkreises**

Filter for adjusting the band width of a control loop

Filtre pour le réglage de la largeur de bande d'une boucle de réglage

(84) Benannte Vertragsstaaten:
**AT CH DE FR GB IT LI NL SE**

(30) Priorität: **02.10.1992 CH 3087/92**

(43) Veröffentlichungstag der Anmeldung:
**06.04.1994 Patentblatt 1994/14**

(73) Patentinhaber:
- **Siemens Schweiz AG**
  **8047 Zürich (CH)**
  Benannte Vertragsstaaten:
  **CH LI**
- **SIEMENS AKTIENGESELLSCHAFT**
  **80333 München (DE)**
  Benannte Vertragsstaaten:
  **DE FR GB IT NL SE AT**

(72) Erfinder: **Gilg, Dietrich**
**CH-8047 Zürich (CH)**

(56) Entgegenhaltungen:
EP-A- 0 571 853     US-A- 4 598 257
US-A- 4 912 434     US-A- 5 121 085

- **IEE PROCEEDINGS-F / RADAR AND SIGNAL PROCESSING Bd. 136, Nr. 1 , Februar 1989 , STEVENAGE, HERTS, GB Seiten 53 - 56 XP4880 Y. R. SHAYAN ET AL. 'ALL DIGITAL PHASE-LOCKED LOOP: CONCEPTS, DESIGN AND APPLICATIONS'**
- **PATENT ABSTRACTS OF JAPAN vol. 11, no. 275 (E-537)5. September 1987 & JP-A-62 073 818 (TOSHIBA AUDIO VIDEO ENG. CORP.) 4. April 1987**

## Beschreibung

Die vorliegende Erfindung betrifft einen Phasenregelkreis nach dem Oberbegriff des Patentanspruchs 1.

Filter jeglicher Art werden sowohl bei der Verarbeitung von analogen als auch von digitalen Signalen verwendet, um bestimmte Informationen aus einem Signal zu extrahieren oder um das Signal aufgrund von definierten Vorgaben aufzubereiten. Insbesondere werden Tiefpass-, Bandpass- und/oder Hochpassfilter zur Unterdrückung mindestens eines Bereichs der in einem Signal vorkommenden Frequenzen verwendet. Derjenige Frequenzbereich, in dem die Amplituden der gefilterten Signale nicht oder nur in unbedeutendem, definiertem Mass verändert werden, wird als Bandbreite bezeichnet, die beim Tiefpassfilter auf der einen Seite durch die Gleichstromkomponente und auf der anderen Seite durch die 3 dB- Grenzfrequenz begrenzt ist. Die 3 dB- Grenzfrequenz ihrerseits entspricht derjenigen Frequenz, bei der die Dämpfung gegenüber der asymptotischen Gleichstromdämpfung um 3 dB grösser ist.

Häufig muss nun die Bandbreite eines Filters oder eines einen Filter enthaltendes Systems variiert werden. Dies ist beispielsweise bei einem Phasenregelkreis (PLL: Phase-Locked Loop) der Fall, bei dem die Phase und die Frequenz eines lokal erzeugten Signals mit einem Eingangssignal synchronisiert werden. Typischerweise besteht ein solcher Phasenregelkreis aus einem Phasenvergleicher und einem Tiefpassfilter als Schleifenfilter in einem Vorwärtspfad und einem spannungsgesteuerten Oszillator (VCO: Voltage- Controlled Oscillator) in einem Rückkopplungpfad. Der Phasenvergleicher reagiert sowohl auf das Eingangs- als auch auf das Ausgangssignal des Phasenregelkreises: Wenn kein Eingangssignal vorhanden ist, gibt der Phasenvergleicher beispielsweise den Wert Null als Eingangssignal an den Oszillator ab, der seinerseits auf einer vorgegebenen freien Frequenz schwingt. Wenn ein Eingangssignal am Phasenregelkreis ansteht, vergleicht der Phasenvergleicher die Phase und Frequenz des Eingangssignals mit dem Ausgangssignal des Phasenregelkreises (Ausgangssignal des Oszillators) und erzeugt ein dem Unterschied entsprechendes Fehlersignal. Dieses meist Stör- und Rauschsignalanteile enthaltende Fehlersignal wird mit Hilfe des Schleifenfilters gefiltert und an den Eingang des Oszillators angelegt. Die Frequenz des Oszillatorausgangssignals wird dabei vom geglätteten Fehlersignal des Schleifenfilters derart gesteuert, dass die Frequenzdifferenz zwischen dem Eingangssignal und dem Ausgangssignal vermindert wird.

Die Wahl des Filtertyps für einen Schleifenfilter stellt beim Entwurf eines Phasenregelkreises einen wesentlichen Entwurfsschritt dar. Insbesondere beeinflusst der gewählte Filter die Bandbreite und somit das dynamische und stationäre Verhalten des Regelkreises in grossem Masse: Wird die Bandbreite des geschlossenen Phasenregelkreises verkleinert, so wird das Fangverhalten verschlechtert, d.h. es dauert längere Zeit bis die Eingangsfrequenz mit der Ausgangsfrequenz sychronisiert ist. Darüber hinaus wird auch der Fangbereich, d.h. der Frequenzbereich, in dem eine Synchronisierung der Eingangs- und Ausgangsfrequenz überhaupt möglich ist, verkleinert. Diesen durch eine Bandbreitenverkleinerung eingehandelten Nachteilen stehen ein verbessertes Störverhalten im synchronisierten Zustand entgegen, da vorhandenes Rauschen und allfällige Störsignale erwartungsgemäss auf einen schmalen Durchlassbereich begrenzt werden. Auf der anderen Seite ist bei einer Bandbreitenvergrösserung zwar die Anfälligkeit des Systems auf Störungen und Rauschen vergrössert, doch wird damit auch der Fangbereich des Phasenregelkreises erweitert. Bei der Wahl der Bandbreite muss demzufolge ein Kompromiss zwischen starker Störsignalunterdrückung bei schmalbandigen Phasenregelkreisen und schneller Synchronisation über grosse Frequenzbereiche bei breitbandigen Phasenregelkreisen eingegangen werden.

Eine Lösung zu dem angesprochenen Dilemma ist beispielsweise aus der Europäischen Patentschrift EP-0 094 837 bekannt. In dieser Druckschrift ist ein analoger Phasenregelkreis beschrieben, der zwei Rückkopplungsschleifen sowie ein Schalter zum Umschalten zwischen den beiden Rückkopplungsschleifen aufweist. Dabei ist die erste Rückkopplungsschleife mit einem zur Synchronisierung des Eingangs- mit dem Ausgangssignal des Phasenregelkreises benötigten Schleifenfilter und einer zweiten Rückkopplungsschleife mit einem Störsignale unterdrückenden Schleifenfilter ausgestattet. Bei Inbetriebsetzung des Phasenregelkreises wird mit Hilfe der ersten Rückkopplungsschleife die Frequenz des Ausgangssignals in die Nähe der Frequenz des Eingangssignals gebracht. Ist der Unterschied in den Frequenzen der beiden Signale kleiner als eine vorgegebene Grösse, so wird mit Hilfe des Schalters automatisch von der ersten auf die zweite Rückkopplungsschleife umgeschaltet. Durch die Umschaltung auf die zweite Rückkopplungsschleife wird die Bandbreite des Phasenregelkreises eingeschränkt und die Störanfälligkeit somit vermindert. Die beschriebene Lösung beinhaltet den wesentlichen Nachteil, dass durch die Umschaltung Sprünge und Spitzen im Fehlersignal entstehen, die nicht selten dazu führen, dass die eben erreichte Synchronisation zwischen Ein- und Ausgangssignal wieder aufgehoben wird. Ferner wird der Schaltungsaufwand bei mehreren, zur Realisierung von verschiedenen Bandbreitenstufen benötigten Schleifenfiltern in sogenannten Filterbänken derart gross, dass ein fehlerfreies Funktionieren mit grossen Schwierigkeiten und entsprechendem erheblichem Aufwand verbunden ist.

Aus Patent Abstracts of Japan, Vol. 11, Nr. 275, Veröffentlichungsnummer JP62073818 ist ein Phasenregelkreis mit einem digitalen Filter bekannt, dessen Bandbreite durch Änderung eines Proportional- und eines Integralanteils der Charakteristik des Filters erfolgt.

Aus U.S. Pat. 5,121,085 ist ferner ein Phasenregelkreis mit einem analogen Schleifenfilter mit umschaltbarer Bandbreite bekannt, bei dem zwei unabhängig regelbare Verstärkungselemente verwendet werden, von denen das erste den Proportionalanteil und das zweite den Integralanteil des VCO-Steuersignals beeinflusst. Dabei wird die Verstärkung des zweiten im Verhältnis zur Verstärkung des ersten Verstärkungselementes vorzugsweise quadratisch geändert. Dabei hat sich jedoch herausgestellt, dass zur korrekten Einstellung der Bandbreite des Phasenregelkreises noch weitere Faktoren zu berücksichtigen sind, die durch diesen bekannten Phasenregelkreis nicht beherrscht werden.

Der vorliegenden Erfindung liegt daher die Aufgabe zugrunde, einen verbesserten Phasenregelkreis mit änderbarer Bandbreite anzugeben.

Diese Aufgabe wird durch die Merkmale des Patentanspruchs 1 gelöst. Vorteilhafte Ausgestaltungen der Erfindung sind in weiteren Ansprüchen angegeben.

Die Erfindung weist folgende Vorteile auf: Die Veränderung der Bandbreite des geschlossenen Regelkreises wird anhand der einstellbaren Filterparameter derart erreicht, dass weitere charakteristische Grössen des geschlossenen Regelkreises, insbesondere die Überhöhung und die Steilheit, in erster Näherung nicht beeinflusst werden. Durch die digitale Realisierung der Filter kann ein störendes Einschwingen durch die Veränderung der Bandbreiten minimal gehalten werden, da den Digitalfiltern die Anfangsbedingungen ohne wesentlichen schaltungstechnischen Mehraufwand vorgegeben werden können. Ferner ist auch ein bei analogen Filtern enormer schaltungstechnischer Aufwand bei digitalen Filterbänken vernachlässigbar klein: Bei einer digitalen Filterbank müssen zwar die verschiedenen Kennwerte der Filter einer Bank verfügbar sein, nicht aber die einzelnen Bausteine, wie dies bei analogen Filterbänken notwendig ist, da die gleichen Bausteine für alle digitalen Filter der Filterbank verwendet werden können. Weiter kann die Bandbreite eines mit erfindungsgemässen digitalen Filtern realisierten Regelkreises sehr schmal eingestellt werden, was bei der Verwendung von analogen Filtern aus Gründen der Realisierbarkeit der dazu benötigten Kennwerte für die Bausteine ausgeschlossen oder aber zumindest mit grössten Schwierigkeiten verbunden ist. Schliesslich zeigen die mit digitalen Bausteinen realisierten Filter keine Veränderungen ihrer Charakteristiken infolge Alterserscheinungen der einzelnen Bausteine, wie dies bei analogen Systemen der Fall sein kann. Ein fehlerloses Funktionieren bei digitalen Filtern ist demzufolge über einen langen Zeitraum hinweg gewährleistet.

Die Erfingung wird nachfolgend anhand von Zeichnungen beispielsweise näher erläutert. Dabei zeigt

Fig. 1    einen Phasenregelkreis,

Fig. 2    ein Bodediagramm einer Übertragungsfunktion des Phasenregelkreises,

Fig. 3    ein Blockdiagramm eines digitalen Filters erster Ordnung in einer "PI-Glied"-Struktur,

Fig. 4    ein erfindungsgemässes digitales Filter und

Fig. 5    eine in diesem Filter verwendete Verstärkungseinheit.

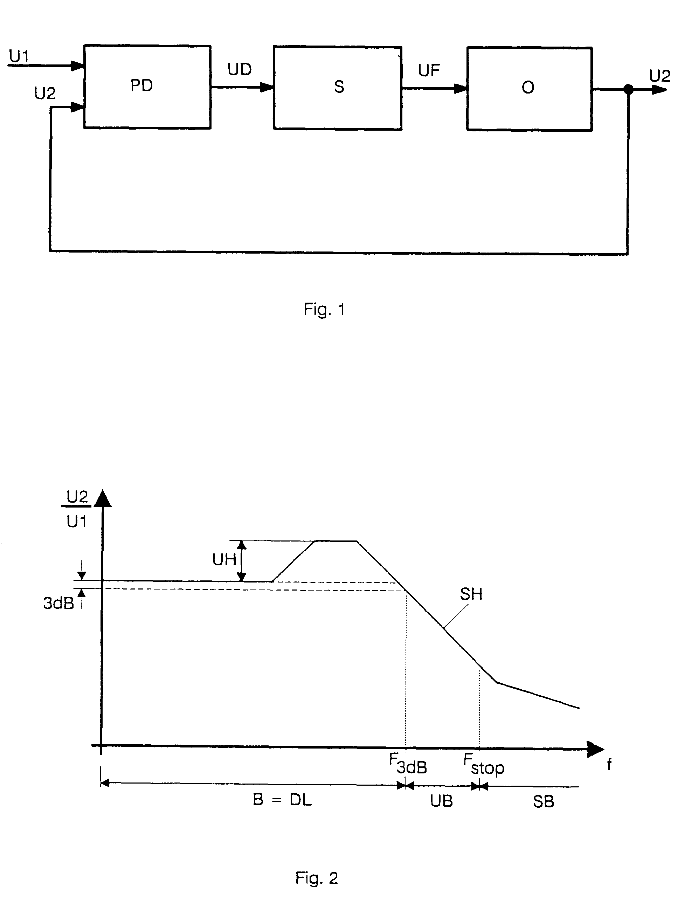

Fig. 1 zeigt einen aus einem Phasenvergleicher PD, einem Filter S und einem spannungsgesteuerten Oszillator O bestehenden bekannten Phasenregelkreis (PLL: Phase Locked Loop), der zur Synchronisation eines Eingangssignals U1 mit einem im Phasenregelkreis erzeugten lokalen Ausgangssignal U2 verwendet wird. Die Phasen und/oder Frequenzen des Eingangs- und des Ausgangssignals U1 bzw. U2 werden im Phasenvergleicher PD miteinander verglichen. Daraus wird ein dem Unterschied in der Phase und/oder Frequenz der beiden Signale entsprechendes Fehlersignal UD abgeleitet und an den Eingang des mit dem Phasenvergleicher PD verbundenen Filters S angelegt. Aus diesem führt ein durch die Verarbeitung des Fehlersignals UD im Filter S erzeugtes Signal UF in den Oszillator O, in dem ein Ausgangssignal U2 erzeugt wird, das eine dem Signal UF entsprechende Frequenz und Phase aufweisen soll. Dazu wird das Fehlersignal UD bzw. das verarbeitete Signal UF derart erzeugt, dass die Frequenz- und/oder die Phasendifferenz zwischen dem Eingangssignal U1 und dem Ausgangssignal U2 vermindert wird.

Wie bereits in der Einleitung erwähnt wurde, spielt das Filter S für das Verhalten des Phasenregelkreises insbesondere deshalb eine entscheidende Rolle, weil die Gesamtübertragungsfunktion des Phasenregelkreises gerade durch die Übertragungsfunktion des Filters S - wie anhand der Beschreibung zu Fig. 2 noch weiter ausgeführt wird - nachhaltig beeinflusst werden kann, währenddem die Übertragungsfunktionen des Phasenvergleichers PD und des Oszillator O meist unveränderbar vorgegeben sind.

Fig. 2 zeigt ein Bodediagramm des Frequenzganges der Übertragungsfunktion des in Fig. 1 dargestellten geschlossenen Phasenregelkreises, wobei der eigentliche Frequenzgang durch deren Asymptoten dargestellt ist. Grundlage der Berechnung dieser Gesamtübertragungsfunktion ist einerseits eine Teilübertragungsfunktion erster Ordnung mit einer Verstärkung $K_d$ für den Oszillator O, sowie eine Teilübertragungsfunktion nullter Ordnung mit einer Verstärkung $K_0$ für den Phasenvergleicher PD. Für das Filter S wird ein PI-Glied mit den beiden Zeitkonstanten $\tau_1$ und $\tau_2$ eingesetzt. Die kontinuierliche Übertragungsfunktion des PI-Gliedes lautet demzufolge:

$$H_{PI}(s) = \frac{1 + \tau_2\, s}{\tau_1\, s}$$

Somit ergibt sich für ein kontinuierliches, geschlossenes Phasenregelkreissystem gemäss Fig. 1 die folgende Gesamtübertragungsfunktion zweiter Ordnung:

$$H_{PLL}(s) = \frac{\tau_2 \, s + 1}{\dfrac{\tau_1}{K_d \, K_0} s^2 + \tau_2 \, s + 1}$$

wobei s eine komplexe Grösse darstellt, die aus einem Realteil σ (Dämpfung) und einem Imaginärteil ω (Kreisfrequenz) besteht. Für die Aufzeichnung des Frequenzganges im Bodediagramm gemäss Fig. 2 wird s = jω gesetzt, d.h. σ = 0, und das Verhältnis von Ausgangs- zu Eingangsamplitude der Signale U1 bzw. U2 im stationären Zustand bezüglich der Frequenz f bzw. der Kreisfrequenz ω aufgetragen. Schliesslich lassen sich aus dem Frequenzgang charakteristische Grössen herauslesen wie beispielsweise eine Überhöhung UH, eine Bandbreite B, eine Steilheit SH oder eine Grenzfrequenz $F_{3dB}$. Die bei Systemen zweiter und höherer Ordnung möglicherweise auftretende Überhöhung UH charakterisiert im wesentlichen - wie auch die Bandbreite B - das dynamische Verhalten des Gesamtsystems. Während die Überhöhung UH ein Mass für die maximale für eine bestimmte Frequenz f auftretende Amplitudenüberhöhung darstellt, entspricht die Bandbreite B demjenigen Frequenzbereich, bei dem Signale mit einer oder mehreren in diesen Frequenzbereich fallenden Frequenzen den Filter S passieren können. Die Begrenzung der Bandbreite B bei tiefpassartigen Systemen besteht auf der einen Seite aus der Gleichstromkomponente (f = 0 Hz) und der 3 dB- Grenzfrequenz $F_{3dB}$, wobei diese Grenzfrequenz $F_{3dB}$ definitionsgemäss derjenigen Frequenz entspricht, bei welcher der Amplitudengang gegenüber der Gleichstromkomponente um 3 dB vermindert ist.

Neben der Bandbreite B, welche annäherungsweise auch etwa mit Durchlassbereich DB bezeichnet wird, kann die Frequenzachse weiter in einen Übergangsbereich UB und einen Sperrbereich SB unterteilt werden. Der Übergangsbereich UB wird dabei auf der einen Seite durch die Grenzfrequenz $F_{3dB}$ und auf der anderen Seite durch eine sogenannte Stoppfrequenz $F_{stop}$ begrenzt. Höhere Frequenzen als die Stoppfrequenz $F_{stop}$ fallen in den Sperrbereich SB.

Entsprechend der Ordnung des Systems stellt sich auch die im Übergangsbereich UB des Frequenzganges vorhandene Steilheit SH ein: Für das vorliegende System zweiter Ordnung liegt diese bei 40 dB/Dekade. Abgesehen von dieser Steilheit SH, die sich aufgrund der Festlegung der Systemordnung ergibt, ändern sich die angegebenen charakteristischen Grössen Überhöhung UH und Grenzfrequenz $F_{3dB}$ auch, wenn beispielsweise eine oder beide der im vorliegenden System veränderbaren Zeitkonstanten $\tau_1$ bzw. $\tau_2$ modifiziert werden. Wegen der Abhängigkeit der charakteristischen Grössen sowohl von der Zeitkonstanten $\tau_1$ als auch von der Zeitkonstanten $\tau_2$ können gezielte Änderungen einer charakteristischen Grösse nur unter bestimmten Bedingungen, und nur indem beide Zeitkonstanten $\tau_1$ und $\tau_2$ verändert werden, vorgenommen werden.

Für das Verhalten des eingangs erwähnten Phasenregelkreises ist es von grosser Bedeutung, dass in der Phase des Einrastens oder des Fangens (Synchronisationsphase) vorzugsweise andere Filter S als Schleifenfilter eingesetzt werden, als in der Phase, in der der Phasenregelkreis eingerastet ist. Dies ergibt sich aus der bereits beschriebenen widersprüchlichen Forderung, dass der geschlossene Phasenregelkreis in der Synchronisationsphase möglichst breitbandig und im eingerasteten Zustand möglichst schmalbandig sein soll. Erfindungsgemäss ist eine Umschaltung zwischen verschiedenen - mindestens jedoch zwei - digitalen Filtern S vorgesehen, wobei in einer Weiterbildung der erfindungsgemässen Lehre als Randbedingung beachtet wird, dass die Struktur der Filter S bestehen und die Überhöhung UH im Frequenzgang der Gesamtübertragungsfunktion des Regelkreises konstant bleiben, währenddem die Bandbreite B beliebig eingestellt wird.

Zur Bestimmung der Form und der benötigten Bausteine für das digitale Filter S wird von der kontinuierlichen Übertragungsfunktion $H_{PI}(S)$ des PI-Gliedes ausgegangen, die mit Hilfe der bilinearen Transformation in ihre digitale Übertragungsfunktion $H_{PI}(z)$ transformiert wird (Alan V. Oppenheim und Ronald W. Schafer, Digital Signal Processing, Prentice-Hall International Inc., London, 1975, Kapitel 5.1.3, Seiten 206 bis 211):

$$H_{PI}(z) = \frac{\dfrac{T_s}{2\,\tau_1} + \dfrac{\tau_2}{\tau_1} + z^{-1}\left(\dfrac{T_s}{2\,\tau_1} - \dfrac{\tau_2}{\tau_1}\right)}{1 - z^{-1}}$$

Neben den bekannten Zeitkonstanten $\tau_1$ und $\tau_2$ enthält die Gleichung $H_{PI}(z)$ als Variable nun eine komplexe Grösse z und eine alle digitalen Systeme kennzeichnende Konstante, die als Abtastintervall $T_s$ bezeichnet wird. Das Abtastintervall $T_s$ ergibt sich dabei aus der zeitlichen Differenz zwischen zwei aufeinanderfolgenden Abtastpunkten.

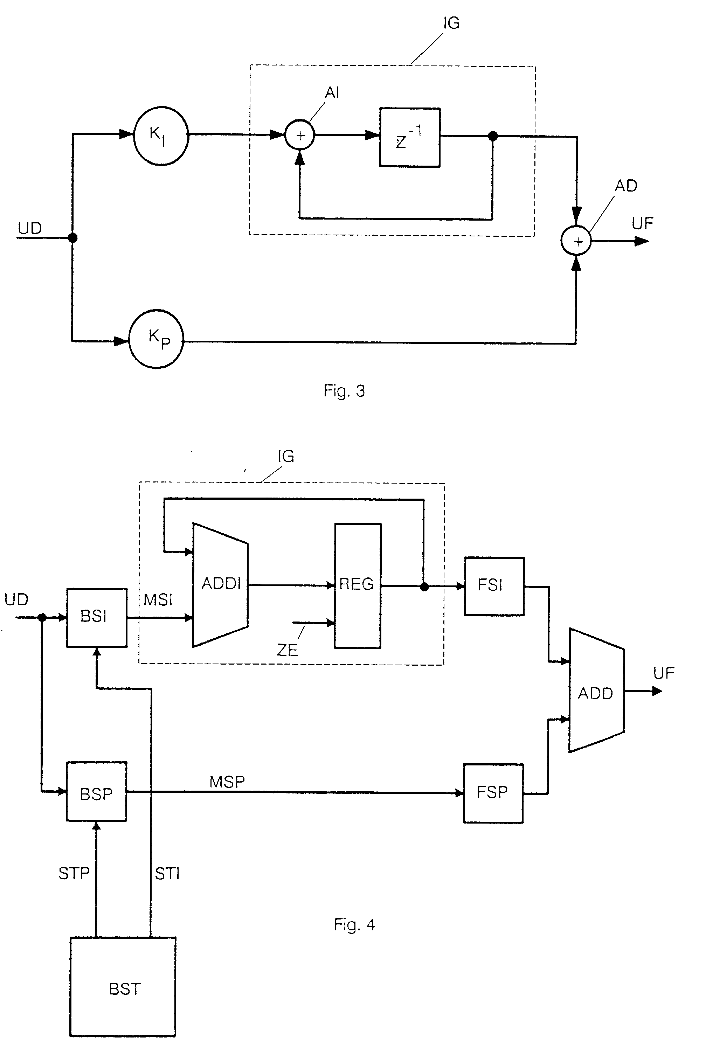

Eine vorteilhafte Realisierungsform eines PI-Gliedes zeigt Fig. 3 anhand eines Blockdiagramms, das die gleiche z- Übertragungsfunktion wie die angegebene Gleichung für $H_{PI}(z)$ aufweist. Die Struktur des Blockdiagramms ist derart gewählt, dass sowohl der P- Anteil als auch der 1- Anteil des PI- Gliedes je in einem Signalpfad liegt. Das Eingangssignal UD wird gemäss Fig. 3 sowohl an den einen Verstärkungsfaktor $K_P$ beinhaltenden P-Anfeil als auch an den parallel zum P-Anteil aus einem Integrator IG und einem weiteren Verstärkungsfaktor $K_I$ bestehenden I-Anteil angelegt. Verbunden werden die beiden parallelen Signal pfade ausgangsseitig durch einen Addierer AD, in dem das Ausgangssignal UF berechnet wird. Der Integrator IG besteht dabei aus einem Verzögerungsglied $Z^{-1}$ und einem weiteren Addierer AI, dessen eine Eingang mit dem Ausgang des Verstärkungsfaktors $K_I$ und dessen anderer Eingang mit dem rückgekoppelten Ausgang des Verzögerungsgliedes $Z^{-1}$ verbunden ist. Die sich aus dem Blockdiagramm von Fig. 3 ergebende z-Übertragungsfunktion $H_{PIF}(z)$ kann durch die in diesem Blockdiagramm angegebenen Parametern wie folgt ausgedrückt werden:

$$H_{PIF}(z) = \frac{K_P + (K_I - K_P)\, z^{-1}}{1 - z^{-1}}$$

Durch Analogieschluss zwischen den den gleichen Filter S darstellenden Übertragungsfunktionen $H_{PIF}(z)$ und $H_{PI}(z)$ werden die Verstärkungsfaktoren $K_I$ und $K_P$ in Funktion der Zeitkonstanten $\tau_1$ und $\tau_2$ und des Abtastintervalls $T_s$ ausgedrückt:

$$K_P = \frac{T_s}{2\,\tau_1} + \frac{\tau_2}{\tau_1}$$

$$K_I - K_P = \frac{T_s}{2\,\tau_1} - \frac{\tau_2}{\tau_1}$$

Als Ausgangspunkt weiterer Berechnungen dient die besagte Randbedingung, dass bei Veränderung der Bandbreite B (Fig. 2) die Überhöhung UH - in der untenstehenden Formel mit $\xi$ bezeichnet - konstant bleibt. Diese Randbedingung kann wie folgt formuliert werden:

$$\xi = \frac{\tau_2}{2}\sqrt{\frac{K_D\, K_O}{\tau_1}} = \text{konstant}$$

Durch Substitution der beiden Zeitkonstanten $\tau_1$ bzw. $\tau_2$, durch die mit Hilfe der im Analogieschluss gewonnenen Beziehungen unter Berücksichtigung der Bedingung, dass die Verstärkungsfaktoren $K_D$ und $K_O$ sowie das Abtastintervall $T_s$ konstant bleiben und unter der Bedingung, dass die Zeitkonstante $\tau_1$ viel grösser ist als das Abtastintervall $T_s$, erhält man folgende Beziehungen für die Verstärkungsfaktoren $K_P$ und $K_I$:

$$K_P \approx C\, 2\,\pi\, F_{3dB}$$

$$K_T \approx D(2\,\pi\, F_{3dB})^2$$

Dabei stellen die beiden Faktoren C und D Grössen dar, die von der Grenzfrequenz $F_{3dB}$ in erster Näherung unabhängig sind.

Somit lässt sich die allgemeine Aussage unter Berücksichtigung der oben angegebenen Einschränkungen wie folgt formulieren: Für eine Verdoppelung der Grenzfrequenz $F_{3dB}$ (im vorliegenden Fall gilt dies auch für die Bandbreite B) muss die Verstärkung $K_P$ des P-Anteils verdoppelt und die Verstärkung $K_I$ des I-Anteils vervierfacht werden. Wird diese lineare und quadratische gegenseitige Abhängigkeit der Verstärkungsfaktoren $K_P$ und $K_I$ beim Einstellen dieser Faktoren berücksichtigt, so erfolgt neben der Veränderung der Bandbreite B keine weitere Veränderung der charakteristischen Grössen. Insbesondere bleibt im Rahmen der getroffenen Annahmen die Überhöhung UH konstant.

Fig. 4 zeigt ein erfindungsgemässes digitales Filter S (Fig. 1) erster Ordnung basierend auf dem in Fig. 3 dargestellten Blockdiagramm. Dabei sind - wie in Fig. 3 - ein mit einem Addierer ADDI und einem Register REG realisierter Integrator IG und ein das Ausgangssignal UF bildender Addierer ADD vorgesehen. Das Eingangssignal UD wird durch in Verstärkungseinheiten BSI und BSP einstellbare Verstärkungsfaktoren $K_{SI}$ und $K_{SP}$ verstärkt, wobei die Verstärkungsfaktoren $K_{SI}$ und $K_{SP}$ vorzugsweise mit Hilfe einer Steuereinheit BST in den Verstärkungseinheiten BSI und BSP eingestellt werden. Am Ausgang des Integrators IG, bzw. des Registers REG, und nach der Verstärkungseinheit BSP sind je eine mit fixierten Verstärkungsfaktoren $K_{FI}$ und/oder $K_{FP}$ ausgestattete weitere Verstärkungseinheiten FSI und/oder FSP vorgesehen, dessen Ausgänge die beiden Summanden des Addierers ADD bilden. Die im Blockdiagramm von Fig. 3 bezeichneten Verstärkungsfaktoren $K_I$ und $K_P$ der beiden Signalpfade für den I- und den P-Anteil setzen sich demzufolge in der realisierten Form von Fig. 4 wie folgt zusammen:

$$K_I = K_{SI}\, K_{FI}$$

$$K_P = K_{SP}\, K_{FP}$$

Während über die Verstärkungsfaktoren $K_{FI}$ und $K_{FP}$ die Grundverstärkung mit Hilfe der Verstärkungseinheiten FSI und FSP des Systems eingestellt und somit die unterschiedliche Grösse der Faktoren C und D kompensiert wird, erfolgt die eigentliche Einstellung der Bandbreite B (Fig. 2) mit Hilfe der in den Verstärkungseinheiten BSI und BSP enthaltenen Verstärkungsfaktoren $K_{SI}$ und $K_{SP}$, d.h. der Verstärkungsfaktor $K_{SP}$ wird in der Verstärkungseinheit BSP linear und der Verstärkungsfaktor $K_{SI}$ in der Verstärkungseinheit BSP quadratisch zur Bandbreite B (Fig. 2) eingestellt.

Durch die Einstellung der Verstärkungsfaktoren $K_{SI}$ und $K_{SP}$ mit Hilfe der Steuereinheit BST lassen sich somit im Rahmen der binären Auflösung beliebige Bandbreiten B (Fig. 2) einstellen. Die Einstellung der Verstärkungsfaktoren $K_{SI}$ und $K_{SP}$ kann aber auch von weiteren Parametern abhängig gemacht werden. Vorstellbar wäre beispielsweise eine direkte Abhängigkeit der Verstärkungsfaktoren $K_{SI}$ und $K_{SP}$ von der Anzahl der in der Synchronisationsphase vorkommenden Phasenüberläufe zwischen Eingangs- U1 und Ausgangssignal U2 des Phasenregelkreises (Fig. 1). Bei einer solchen Abhängigkeit wird die über die Verstärkungsfaktoren $K_{SI}$ und $K_{SP}$ einstellbare Bandbreite B (Fig. 2) beispielsweise proportional zu der Anzahl Phasenüberläufe vergrössert bzw. verkleinert. Somit erfolgt eine dauernde Anpassung an die ändernden Störeinflüsse des Phasenregelkreises.

Um ein bei einer Bandbreitenumschaltung entstehendes Einschwingen möglichst klein zu halten, können die Anfangsbedingungen, d.h. der Wert im Register REG, durch eine Registerzuführung ZE eingestellt werden. Die Registerzuführung ZE stellt somit einen weiteren Eingang des Filters S dar.

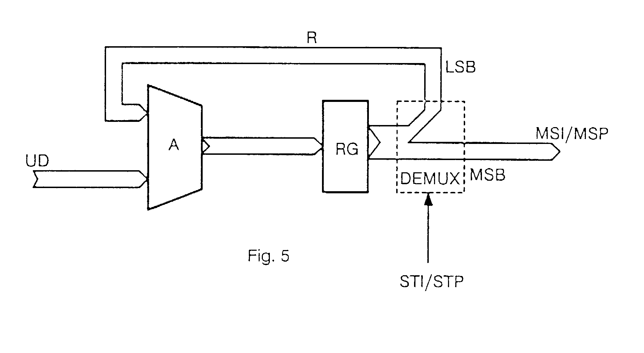

Fig. 5 zeigt eine in Fig. 4 dargestellte Verstärkungseinheit BSI bzw. BSP, in der die Verstärkung bzw. Abschwächung des Eingangssignals UD durch eine Verschiebung von einzelnen oder ganzen Gruppen von niederwertigen Bits mit Hilfe eines Demultiplexers DEMUX vorgenommen wird. Das Eingangssignal UD wird dazu zusammen mit einem vom Demultiplexer DEMUX stammenden Rückkopplungssignal R auf einen Addierer A gegeben, dessen Ausgangswert in einem Register RG abgelegt wird. Aus dem an den Demultiplexer DEMUX anstehenden Signal werden entsprechend einem von der Steuereinheit BST (Fig. 4) abgegebenen Steuerwert STI bzw. STP einzelne oder eine zusammenhängende Gruppe von niederwertigen Bits LSB ausgewählt und über das Rückkopplungssignal R an den Addierer A zurückgeführt. Die restlichen nicht zurückgeführten Bits MSB des Registerausgangssignals bilden das eigentliche Ausgangssignal MSI bzw. MSP der Verstärkungseinheit BSI bzw. BSP (Fig. 4).

Durch die Rückführung und Wiedereinbeziehung der bei der Abschwächung verschobenen und nicht mehr zum Ausgangssignal MSI bzw. MSP der Verstärkungseinheit BSI bzw. BSP gehörenden Bits LSB in das Eingangssignal UD werden Rundungsfehler zum Teil kompensiert, da der in der Bitgruppe LSB enthaltene Wert bei jedem Durchlauf eines Abtastwertes zum Eingangssignal UD addiert wird. Alle Rundungsfehler werden auf diese Weise im Register RG akkumuliert und beeinflussen das Ausgangssignal der Verstärkungseinheit BSI bzw. BSP, wenn immer ein Überlauf in den Wertebereich des Ausgangssignals MSI bzw. MSP erfolgt.

Für den Demultiplexer DEMUX können allgemein bekannte elektronische Demultiplexer eingesetzt werden, wobei pro Binärstelle, d.h. pro Leitung, ein Demultiplexer benötigt wird.

Der Einsatz des beschriebenen digitalen Filters S (Fig. 4) ist nicht auf die Verwendung in einem Phasenregelkreis beschränkt. Vielmehr eignet sich ein solches Filter S in Regelkreisen mit ähnlichen Übertragungsfunktionen, insbesondere aber in Regelkreisen mit Übertragungsfunktionen zweiter Ordnung und insbesondere immer dann, wenn die Forderung nach einer variablen Bandbreite B (Fig. 2) bei veränderbarer oder gleichbleibender Überhöhung UH besteht. Solche andere Regelkreise gehören aber nicht zu der Erfindung.

**Patentansprüche**

1. Phasenregelkreis wenigstens zweiter Ordnung mit einem Phasenvergleicher (PD), dem ein Referenzsignal (U1) und das Ausgangssignal (U2) eines spannungsgesteuerten Oszillators (O) zugeführt werden und der ein Fehlersignal (UD) an ein steuerbares digitales Filter (S) abgibt, durch dessen Ausgangssignal (UF) der Oszillator (O) steuerbar ist, wobei das Filter (S) ein PI-Glied mit einem wenigstens eine erste Verstärkungseinheit (BSP) aufweisenden P-Anteil sowie einem wenigstens eine zweite Verstärkungseinheit (BSI) aufweisenden I-Anteil enthält, wobei die erste und die zweite Verstärkungseinheit (BSP; BSI) durch eine Steuereinheit (BST) steuerbar sind, **dadurch gekennzeichnet,** dass der Verstärkungsfaktor $K_{SI}$ der zweiten Verstärkungseinheit (BSI) relativ zum Verstärkungsfaktor $K_{SP}$ der ersten Verstärkungseinheit (BSP) durch die Steuereinheit (BST) stets quadratisch geändert wird, dass im P-Anteil eine dritte, einen konstanten Verstärkungsfaktor $K_{FP}$ aufweisende Verstärkungseinheit (FSP) und im I-Anteil eine vierte, einen konstanten Verstärkungsfaktor $K_{FI}$ aufweisende Verstärkungseinheit (FSI) vorgesehen ist, wobei durch die Wahl der konstanten Verstärkungsfaktoren $K_{FP}$ und $K_{FI}$ die Grundverstärkung und durch die Wahl der variablen Verstärkungsfaktoren $K_{SP}$, $K_{SI}$ die den Durchlassbereich (DL) des geschlossenen Regelkreises charakterisierende Bandbreite B einstellbar ist.

2. Phasenregelkreis nach Anspruch 1, **dadurch gekennzeichnet**, dass das Fehlersignal (UD) der ersten und zweiten Verstärkungseinheit (BSP; BSI) zuführbar ist, dass der Ausgang der ersten Verstärkungseinheit (BSP) über die dritte Verstärkungseinheit (FSP) und der Ausgang der zweiten Verstärkungseinheit (BSI) über einen Integrator (IG) und die vierte Verstärkungseinheit (FSI) je mit einem Eingang eines ersten Addierers (ADD) verbunden sind, der durch Addition zugeführten Signale das Ausgangssignal (UF) des Filters (S) bildet.

3. Phasenregelkreis nach Anspruch 2, **dadurch gekennzeichnet**, dass der Integrator (IG) einen weiteren Addierer (ADDI) aufweist, dessen Ausgang über ein erstes Register (REG) mit dem Eingang der vierten Verstärkungseinheit (FSI) verbunden ist und dessen erster Eingang mit dem Ausgang des ersten Registers (REG) und dessen zweiter Eingang mit dem Ausgang der zweiten Verstärkungseinheit (BSI) verbunden ist.

4. Phasenregelkreis nach Anspruch 3, **dadurch gekennzeichnet**, dass der im ersten Register (REG) gespeicherte Wert über einen zusätzlichen Registereingang (ZE) jederzeit beliebig einstellbar ist.

5. Phasenregelkreis nach Anspruch 1, 2, 3 oder 4, **dadurch gekennzeichnet,** dass die erste und zweite Verstärkungseinheit (BSP; BSI) einen dritten Addierer (A) aufweisen, der über ein zweites Register (RG) mit einem mit der dritten bzw. vierten Verstärkungseinheit (FSP; FSI) verbundenen Demultiplexer (DEMUX) verbunden ist, durch den in Abhängigkeit des einzustellenden Verstärkungsfaktors $K_{SI}$ bzw. $K_{SP}$ einzelne oder zusammenhängende Gruppen von niederwertigen Bits auswählbar und an den ersten Eingang des dritten Addierers (A) rückführbar sind, dessen zweiter Eingang mit dem Fehlersignal (UD) beaufschlagt ist.

6. Phasenregelkreis nach Anspruch 5, **dadurch gekennzeichnet**, dass die durch den Demultiplexer (DEMUX) aus dem Wertebereich des übertragenen Wertes geschobenen Bits LSB beim nächsten zu übertragenden Wert berücksichtigbar sind.

7. Phasenregelkreis nach einem der Ansprüche 1 - 6, **dadurch gekennzeichnet**, dass die Verstärkungsfaktoren $K_{FP}$ und $K_{FI}$ derart gewählt sind, dass durch sie die in den beiden Gleichungen:

$$K_{FP} * K_{SP} \approx C \, 2 \, \pi \, F_{3dB} \text{ und}$$

$$K_{FI} * K_{SI} \approx D \, (2 \, \pi \, F_{3dB})^2$$

enthaltenen Konstanten C und D zumindest annähernd kompensiert werden.

**Claims**

1. Phase-locked loop, at least second-order, having a phase comparator (PD) to which a reference signal (U1) and the output signal (U2) of a voltage-controlled oscillator (O) are supplied and which outputs an error signal (UD) to a controllable digital filter (S), by the output signal (UF) of which the oscillator (O) can be controlled, with the filter (S) containing a PI-element which has a P-portion having at least one first amplification unit (BSP) and an I-portion having at least one second amplification unit (BSI), with the first and second amplification units (BSP; BSI) being controllable by a control unit (BST), characterised in that the amplification factor $K_{SI}$ of the second amplification unit (BSI) is always altered quadrically relative to the amplification factor $K_{SP}$ of the first amplification unit (BSP) by the control unit (BST), in that provided in the P-portion is a third amplification unit (FSP) which has a constant amplification factor $K_{FP}$ and provided in the I-portion is a fourth amplification unit (FSI) which has a constant amplification factor $K_{FI}$, with the basic amplification being adjustable by the selection of the constant amplification factors $K_{FP}$ and $K_{FI}$ and the band width B which characterises the transmission band (DL) of the closed control loop being adjustable by the selection of the variable amplification factors $K_{SP}$, $K_{SI}$.

2. Phase-locked loop according to claim 1, characterised in that the error signal (UD) can be supplied to the first and second amplification units (BSP; BSI), in that the output of the first amplification unit (BSP) is connected to an input of a first adder (ADD) by way of the third amplification unit (FSP) and the output of the second amplification unit (BSI) is connected to said input by way of an integrator (IG) and the fourth amplification unit (FSI), which adder forms the output signal (UF) of the filter by addition of supplied signals.

3. Phase-locked loop according to claim 2, characterised in that the integrator (IG) has a further adder (ADDI), the output of which is connected by way of a first register (REG) to the input of the fourth amplification unit (FSI) and the first input of which is connected to the output of the first register (REG) and the second input of which is connected to the output of the second amplification unit (BSI).

4. Phase-locked loop according to claim 3, characterised in that the value stored in the first register (REG) can be adjusted in any way at any time by way of an additional register input (ZE).

5. Phase-locked loop according to claim 1, 2, 3 or 4, characterised in that the first and second amplification units (BSP; BSI) have a third adder (A), which is connected by way of a second register (RG) to a demultiplexer (DEMUX) which is connected to the third and fourth amplification units (FSP; FSI) respectively and by which, as a function of the amplification factor $K_{SI}$ or $K_{SP}$ to be adjusted, individual or connected groups of low-value bits can be selected and passed back to the first input of the third adder (A), to the second input of which the error signal (UD) is applied.

6. Phase-locked loop according to claim 5, characterised in that the bits LSB which have been shifted out of the range of values of the transmitted value by the demultiplexer (DEMUX) can be taken into account in the next value to be transmitted.

7. Phase-locked loop according to one of claims 1 to 6, characterised in that the amplification factors $K_{FP}$ and $K_{FI}$ are selected in such a way that by them the constants C and D contained in the two equations:

$$K_{FP} * K_{SP} \approx C\, 2\, \pi\, F_{3dB}$$

and

$$K_{FI} * K_{SI} \approx D(2\, \pi\, F_{3dB})^2$$

are at least approximately compensated.

## Revendications

1. Boucle à phase asservie au moins du deuxième ordre, comportant un comparateur (PD) de phase, auquel est envoyé un signal (U1) de référence et le signal (U2) de sortie d'un oscillateur (O) commandé par la tension et qui fournit un signal (UD) d'erreur à un filtre (S) numérique, qui peut être commandé et par le signal (UF) de sortie duquel l'oscillateur (O) peut être commandé, le filtre (S) contenant un élément PI ayant une composante (P) comportant au moins une première unité (BSP) d'amplification, ainsi qu'une composante I comportant au moins une deuxième unité (BSI) d'amplification, la première et la deuxième unité (BSP;BSI) d'amplification pouvant être commandées par une unité (BST) de commande, caractérisée en ce que le facteur $K_{SI}$ d'amplification de la deuxième unité (BSI) d'amplification est modifié par l'unité (BST) de commande toujours de manière quadratique par rapport au facteur $K_{SP}$ d'amplification de la première unité (BSP) d'amplification, en ce qu'il est prévu, dans la composante P, une troisième unité (FSP) d'amplification ayant un facteur $K_{FP}$ d'amplificateur constant et, dans la composante 1, une quatrième unité (FSI) d'amplification ayant un facteur $K_{FI}$ d'amplification constant, l'amplification de base pouvant être réglée par le choix des facteurs $K_{FP}$ et $K_{FI}$ d'amplification constants et la largeur B de bande caractérisant la bande (DL) passante de la boucle fermée pouvant être réglée par le choix des facteurs $K_{SP}$, $K_{SI}$ d'amplification variables.

2. Boucle à phase asservie suivant la revendication 1, caractérisée en ce que le signal (UD) d'erreur peut être envoyé à la première et à la deuxième unité (BSP;BSI) d'amplification, en ce que la sortie de la première unité (BSP) d'amplification et la sortie de la deuxième unité (BSI) d'amplification sont reliées, respectivement par l'intermédiaire de la troisième unité (FSP) d'amplification et par l'intermédiaire d'un intégrateur (IG) et de la quatrième unité (FSI) d'amplification, chacune a une entrée d'un premier additionneur (ADD), qui forme par addition de signaux envoyés le signal (UF) de sortie du filtre (S).

3. Boucle à phase asservie suivant la revendication 2, caractérisée en ce que l'intégrateur (IG) comporte un additionneur (ADDI) supplémentaire, dont la sortie est reliée à l'entrée de la quatrième unité (FSI) d'amplification par l'intermédiaire d'un premier registre (REG) et dont la première entrée est reliée à la sortie du premier registre (REG) et dont la deuxième entrée est reliée à la sortie de la deuxième unité (BSI) d'amplification.

4. Boucle à phase asservie suivant la revendication 3, caractérisée en ce que la valeur mémorisée dans le premier registre (REG) peut être réglée à tout moment de manière quelconque par l'intermédiaire d'une entrée (ZE) de registre supplémentaire.

5. Boucle à phase asservie suivant la revendication 1, 2, 3 ou 4, caractérisée en ce que la première unité (BSP) d'amplification et la deuxième unité (BSI) d'amplification comportent un troisième additionneur (A) qui est relié, par l'intermédiaire d'un deuxième registre (RG), à un démultiplexeur (DEMUX) qui est relié à la troisième unité (FSP) d'amplification et à la quatrième unité (FSI) d'amplification et par lequel, en fonction des facteurs $K_{SI}$ et $K_{SP}$ d'amplification à régler, des groupes individuels ou continus de bits de petit poids peuvent être sélectionnés et envoyés à la première entrée du troisième additionneur (A), dont la deuxième entrée est alimentée en le signal (UD) d'erreur.

6. Boucle à phase asservie suivant la revendication 5, caractérisée en ce que les bits LSB déplacés par le démultiplexeur (DEMUX) en dehors de l'intervalle de valeur de la valeur transmise peuvent être pris en compte pour la prochaine valeur à transmettre.

7. Boucle à phase asservie suivant l'une des revendications 1 à 6, caractérisée en ce que les facteurs $K_{FP}$ et $K_{FI}$ d'amplification sont choisis de telle manière que les constantes C et D contenues dans les deux équations:

$$K_{FP} * K_{SP} \approx C\, 2\, \pi\, F_{3dB}$$

et

$$K_{FI} * K_{SI} \approx D\, (2\, \pi\, F_{3dB})^2$$

sont au moins à-peu-près compensées par eux.

Fig. 1

Fig. 2

Fig. 3

Fig. 4

Fig. 5